# EUROPEAN PATENT APPLICATION

(11) **EP 3 525 116 A1**
(43) Date of publication of application: **14.08.2019**
(21) Application number: 18156323.0
(22) Date of filing: 12.02.2018
(51) Int. Cl.: G06F 17/50

(54) **MANAGEMENT SYSTEM OF ELECTRICAL FIELD CIRCUIT DESIGN**

(71) Applicant: Plmsoft Co., Ltd, Seoul 08507 (KR)
(72) Inventor: Ko, Eun Jun, 16862 Yongin-si (KR); Kim, Jean Ho, 08532 Seoul (KR)
(74) Representative: Loo, Chi Ching

(57) **Abstract**

Disclosed is a management system of an electrical field circuit design including: a rule generator that generates a rule applied individually to a specific device of a specific project; a rule manager that manages a generation rule generated by the rule generator, a basic wire rule for the electrical field design, and a device rule; a rule check unit that determines whether to apply and match a basic wire rule and a device rule to the inputted electrical field circuit design, confirms a project of the electrical field circuit design, and determines whether to apply and match the generation rule to a specific device included therein; and a result generator that generates a matching result of the basic wire rule, the device rule, and the generation rule.

## Description

### BACKGROUND

### (a) Technical Field

The present invention relates to a management system of an electrical field circuit design and more particularly, to a management system of an electrical field circuit design which may be used in an electrical field design program such as an engineering base (EB), an EPLAN, auto CAD electrical, and the like.

### (b) Background Art

An electrical field is a function to electrically connect various electronic and control apparatuses mounted on automobiles and aircrafts. The number of these electronic and control apparatuses is gradually increasing, and the configuration of the electrical field is more complicated.

Such an electrical field varies according to uses of aircrafts, automobiles, electronic products, and the like, but is basically configured by devices such as wires, bundles, connectors, terminals, joins, and the like.

The design of the electrical field is performed at the end of the design step, and as the design changes are made frequently, the change of the design should be easy and a history management should be performed thoroughly whenever the design is changed.

However, in the current method of managing the electrical field design, after a designer prepares the electrical field design as a program and outputs a document, when the electrical field design is verified and approved and handed over to a designer in a next stage, there are cases where problems of the previous design are caused when the designer in the next stage makes the design, and if the compatibility and connectivity problems arise, the design should be revised again.

This process is recognized as an irrational method that takes a lot of time, and a parts list or a routing list required for design modifications is not secured as computerized data, and thus, there is a problem that the designer needs to find documents one by one.

As a result, when the initial electrical field design is completed, it is necessary to perform many steps in order to finally obtain the verification and approval. However, reliability of the history management of the electrical field design is lost due to the problem that any part is paid using a network and any part is paid on a document, and there is a problem that it takes a lot of time to confirm the details for components used in the design.

### SUMMARY OF THE DISCLOSURE

The present invention has been made in an effort to provide a management system of an electrical field circuit design capable of being managed for each specific project and each specific device and registering, changing, correcting, and deleting a design rule according to a need of a manager and a user.

Further, the present invention has been made in an effort to provide a management system of an electrical field circuit design capable of easily determining linkage of an electrical field design for each project performed by another subject by comparing a completion degree of the circuit design with a user edit rule other than a standard specification and determining the completion degree.

An exemplary embodiment of the present invention provides a management system of an electrical field circuit design including: a rule generator that generates a rule applied individually to a specific device of a specific project; a rule manager that manages a generation rule generated by the rule generator, a basic wire rule for the electrical field design, and a device rule; a rule check unit that determines whether to apply and match a basic wire rule and a device rule to the inputted electrical field circuit design, confirms a project of the electrical field circuit design, and determines whether to apply and match the generation rule to a specific device included therein; and a result generator that generates a matching result of the basic wire rule, the device rule, and the generation rule.

The rule generator may generate and register a rule including at least one parameter of a device type, a connection condition, an attribute name, an attribute type, an attribute value, an attribute value condition, a code master, a target device condition, and a setting range.

The rule generator may distinguish a hierarchical structure between generation rules using at least one registered parameter of the device type, the connection condition, the attribute name, the attribute type, the attribute value, the attribute value condition, the code master, the target device condition, and the setting range.

The rule generator may provide an interface for updating, changing, and deleting the generation rule.

The result generator may generate the matching result for each device or wire.

The rule check unit may determine whether or not to match the generation rule by distinguishing a rule for determining whether or not to match the generation rule according to the input of the user and a rule for not determining.

According to the present invention, the electrical field circuit design can be managed for each specific project and each specific device and register, change, correct, and delete a design rule according to a need of a manager and a user.

Further, it is possible to easily determine linkage of an electrical field design for each project performed by another subject by comparing a completion degree of the circuit design with a user edit rule other than a standard specification and determining the completion degree.

### BRIEF DESCRIPTION OF THE DRAWINGS

The above and other features of the present invention will now be described in detail with reference to certain exemplary embodiments thereof illustrated the accompanying drawings which are given hereinbelow by way of illustration only, and thus are not limitative of the present invention, and wherein:
FIG. 1 is a block diagram of a management system of an electrical field circuit design according to an exemplary embodiment of the present invention;
FIGS. 2 to 8 are diagrams for describing an operation of the management system of the electrical field circuit design according to the exemplary embodiment of the present invention; and
FIGS. 8 to 14 are diagrams for describing a generation rule operation of the management system of the electrical field circuit design according to the exemplary embodiment of the present invention.

### DETAILED DESCRIPTION

The present invention may have various modifications and various exemplary embodiments and specific exemplary embodiments will be illustrated in the drawings and described in detail. However, this does not limit the present invention to specific exemplary embodiments, and it should be understood that the present invention covers all the modifications, equivalents and replacements included within the idea and technical scope of the present invention.

Terms including an ordinary number, such as 'first' and 'second', are used for describing various constituent elements, but the constituent elements are not limited by the terms. The terms are used only to discriminate one constituent element from another component. For example, a first constituent element may be named as a second constituent element and similarly, the second constituent element may be named as the first constituent element without departing from the scope of the present invention. A term 'and/or' includes a combination of a plurality of associated disclosed items or any item of the plurality of associated disclosed items.

It should be understood that, when it is described that a component is "connected to" or "accesses" another component, the component may be directly connected to or access the other component or a third component may be present therebetween. In contrast, it should be understood that, when it is described that an element is "directly connected to" or "directly access" another element, it is understood that no element is present between the element and another element.

Terms used in the present application are used only to describe specific embodiments, and are not intended to limit the present invention. A singular form may include a plural form if there is no clearly opposite meaning in the context. In the present application, it should be understood that term "include" or "have"indicates that a feature, a number, a step, an operation, a component, a part or the combination thereof described in the specification is present, but does not exclude a possibility of presence or addition of one or more other features, numbers, steps, operations, components, parts or combinations thereof, in advance.

If it is not contrarily defined, all terms used herein including technological or scientific terms have the same meanings as those generally understood by a person with ordinary skill in the art. Terms defined in generally used dictionary shall be construed that they have meanings matching those in the context of a related art, and shall not be construed in ideal or excessively formal meanings unless they are clearly defined in the present application.

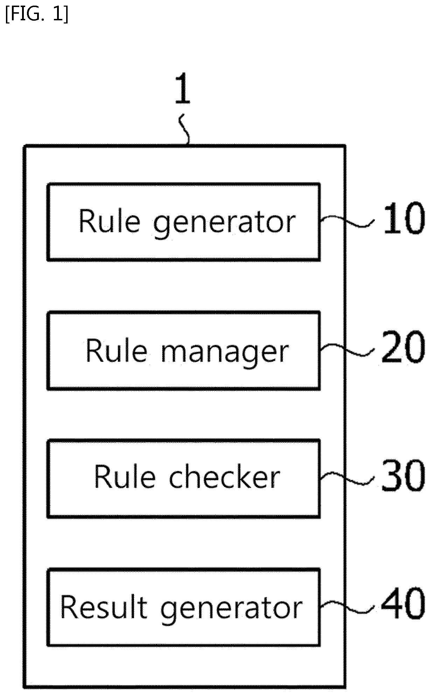

FIG. 1 is a block diagram of a management system of an electrical field circuit design according to an exemplary embodiment of the present invention.

Referring to FIG. 1, a management system 1 of an electrical field circuit design according to an exemplary embodiment of the present invention may include a rule generator 10, a rule manager 20, a rule checker 30, and a result generator 40.

First, the rule generator 10 may create a rule that is individually applied to a specific device of a specific project. The rule generator 10 may provide a rule generation tool to a manager or a user and generate the created rule using the tool. The rule generator 10 may provide basic parameters for generating the rule. The rule generator 10 may generate and register a rule including at least one parameter of, for example, a device type, a connection condition, an attribute name, an attribute type, an attribute value, an attribute value condition, a code master, a target device condition, and a setting range.

The rule generator 10 may provide a tool so that the manager or the user may set the parameters and generate and register a rule according to a value input to the tool.

Herein, the device type means a type of component used in the electrical field circuit design. For example, the device type may refer to all types of electrical devices including a circuit breaker, a motor, a clamp, a pump, a controller, and the like.

The connection condition may refer to a linkage condition between rules and may be set using logical conditions such as AND, OR, NOR, and NAND.

The attribute name means an attribute defined for each device type, and may mean a unique attribute such as a product number, a device name, a weight, and a use voltage.

The attribute type is a type of value that may be input to an attribute, and may be configured by a string, an integer, and a reference. Herein, the string may be an attribute type when a condition attribute of a target device is a string, the integer may be an attribute type when the condition attribute of the target device is a figure, and the reference may be classified as an attribute referring to another device.

The attribute value is a parameter that distinguishes a MAIN device from other devices.

The attribute value condition may be selected and used from formulas "<", ">", "=", "!=", ">=", and "<=" as a place which receives a condition of the input attribute value.

The code master is a parameter for setting a representative value and a unit of the input attribute value, and in the case of the representative value, various values which may be expressed by the user may be changed to a designated representative value and in the case of the unit value, various unit values which may be used by the user may be changed to a common unit value.

In addition, the rule generator 10 may distinguish a hierarchical structure between generation rules using at least one registered parameter of a device type, a connection condition, an attribute name, an attribute type, an attribute value, an attribute value condition, a code master, a target device condition, and a setting range. The generation rule is divided and applied for each project and device, and the rule generator may determine a linkage structure between the generated rules and distinguish a hierarchical structure between a generation rule of a high layer and a generation rule of a lower layer. For example, the rule generator may distinguish a hierarchical structure between a generation rule of a specific device and a generation rule of a device connected to a lower end thereof by referring to the device type. Alternatively, the rule generator may classify a generation rule between the MAIN device and other devices into a generation rule of the high layer and a generation rule of the lower layer using the attribute value, respectively.

Further, the rule generator 10 may provide an interface for updating, changing, and deleting the generation rule.

Next, the rule manager 20 may manage a generation rule generated by the rule generator 10, a basic wire rule for the electrical field design, and a device rule.

The basic wire rule is a rule that cannot be changed or deleted by the manager or the user and includes, for example, a floating wire check rule, a ground connection check rule, an N/C Pin connection check rule, an attribute check rule of a color of a wire and a pin, and the like. The change and the delete of the basic wire rule is impossible, but the manager or the user may determine whether or not to apply an applied basic wire rule and a non-applied basic wire rule during a matching operation of a rule check unit.

The device rule is a rule which cannot be changed or deleted by the manager or the user and may include, for example, a rule that a thickness of a ground wire needs to be dependant on a thickness of a power supply wire. The change and the delete of the device rule is impossible, but the manager or the user may determine whether or not to apply an applied basic wire rule and a non-applied basic wire rule during a matching operation of the rule check unit.

The rule check unit 30 may determine whether to apply and match a basic wire rule and a device rule to the inputted electrical field circuit design, confirm a project of the electrical field circuit design, and determine whether to apply and match a generation rule to a specific device included therein.

The rule check unit 30 determines whether to match the basic wire rule and the device rule when the electrical field circuit design is input and determines an error. The rule check unit 30 determines whether to apply and match the basic wire rule and the device rule to the wire and the device included in the electrical field circuit design, respectively.

Further, the rule check unit 30 confirms a project linked with the corresponding electrical field circuit design when the electrical field circuit design is input and searches the generation rule generated for the corresponding project. The rule check unit 30 determines whether to apply and match the generation rule to the corresponding device using the searched generation rule.

In addition, the rule check unit 30 may determine whether or not to match the generation rule by distinguishing a rule for determining whether or not to match the generation rule according to the input of the user and a rule for not determining. The rule check unit compares remaining searched generation rules except for the generation rule excluding the application by the user among the searched generation rules and determines whether to match the generation rules.

The result generator 40 may generate a matching result of the basic wire rule, the device rule, and the generation rule. The result generator 40 may generate and output the matching result for each device or wire.

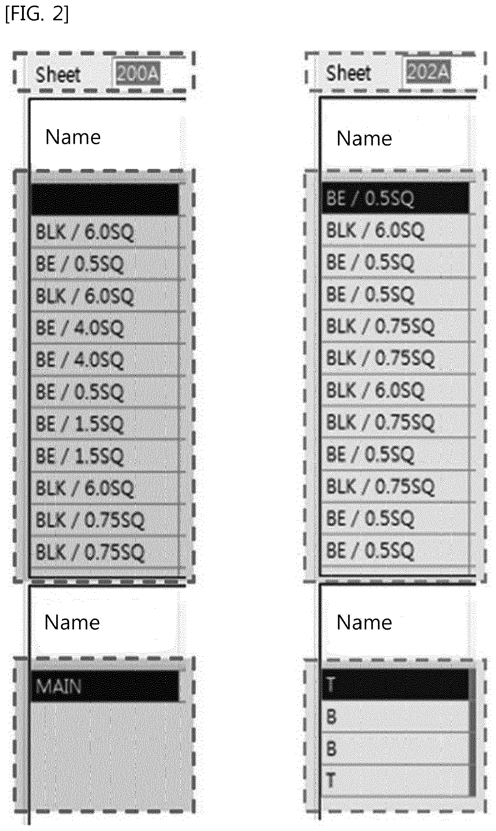

FIGS. 2 to 8 are diagrams for describing an operation of the management system of the electrical field circuit design according to the exemplary embodiment of the present invention.

Referring to FIG. 2, when the electrical field circuit design is input, a project of the corresponding electrical field circuit design, a wire included therein, and a device list are recognized.

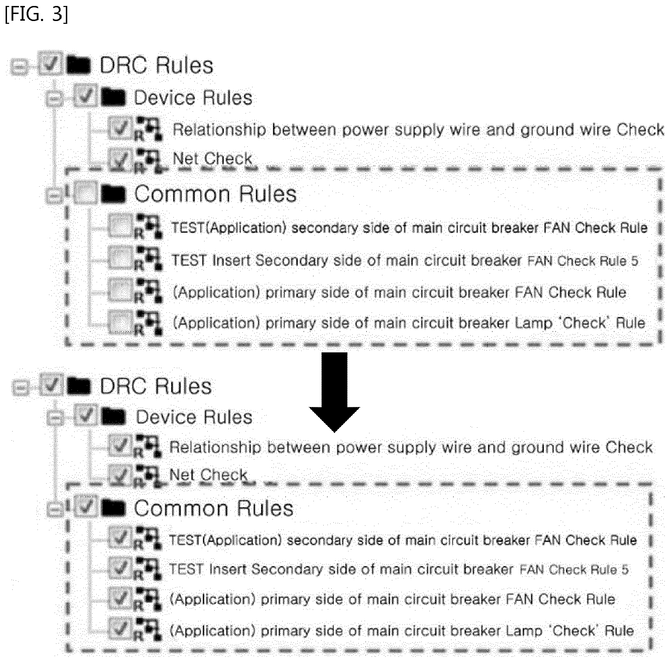

Referring to FIG. 3, a basic wire rule, a device rule, and a generation rule to be applied to the input electrical field circuit design are loaded. In this case, the manager or the user may select a rule to be applied.

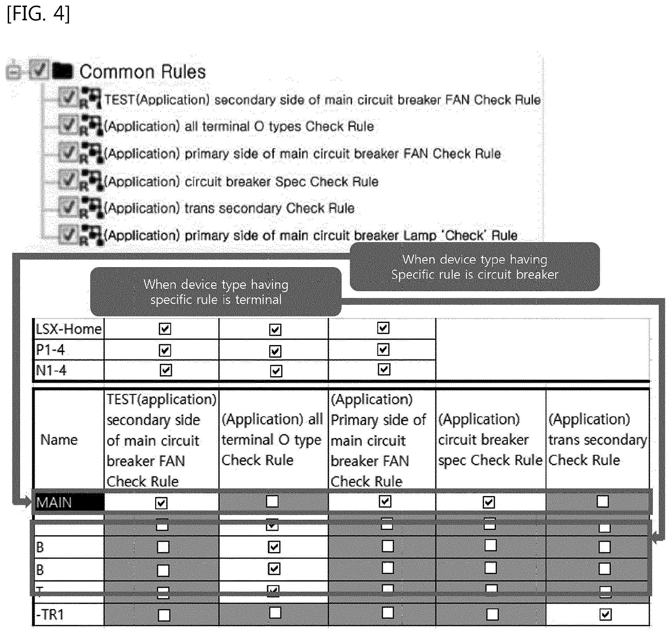

Referring to FIG. 4, the manager or the user checks a device to be applied with the generation rule for each item to perform randomly the rule check.

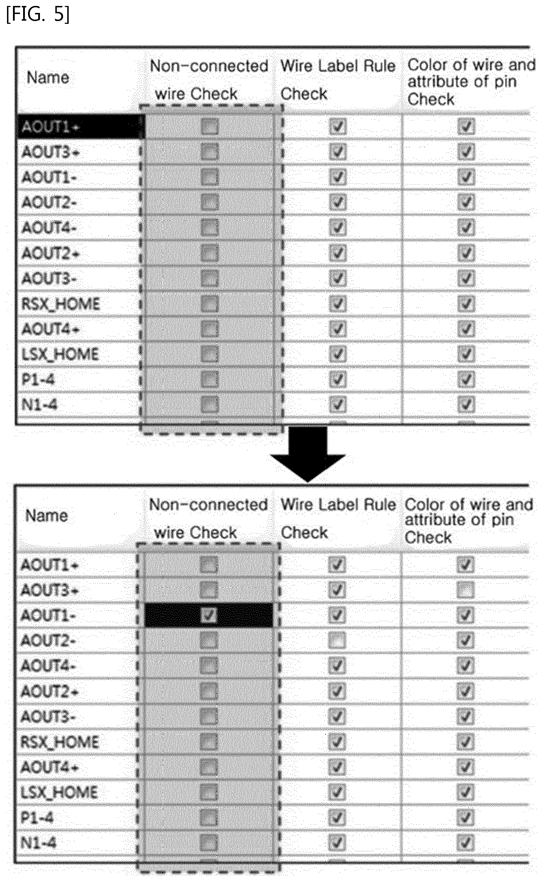

Referring to FIG. 5, the manager or the user may check a wire rule for application for each wire among the wire rules of the input electrical field circuit design.

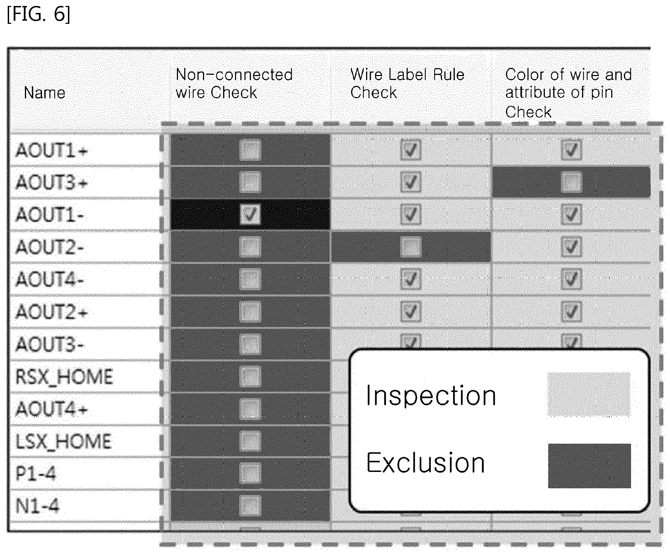

Referring to FIG. 6, it is determined whether or not to match only items checked for each wire among the respective wire rules.

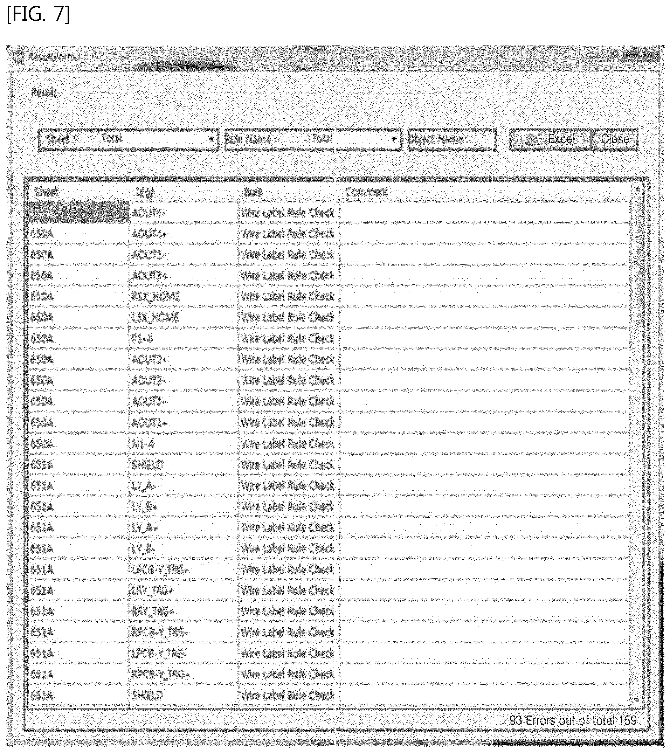

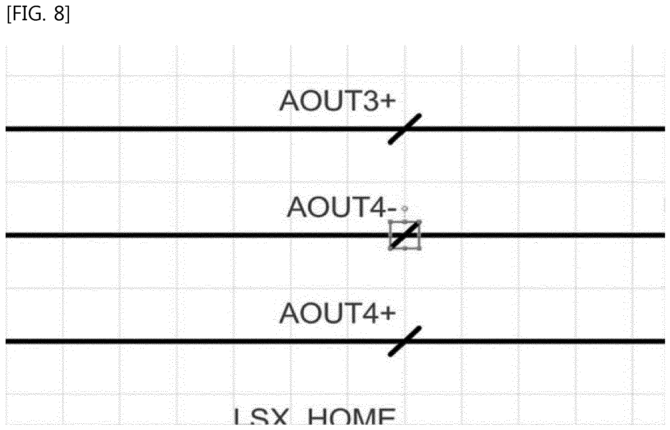

Referring to FIG. 7, a result of matching the wire rule is prepared and output as a list and referring to FIG. 8, a result of determining whether to match the wire rule is illustrated together with a wire name.

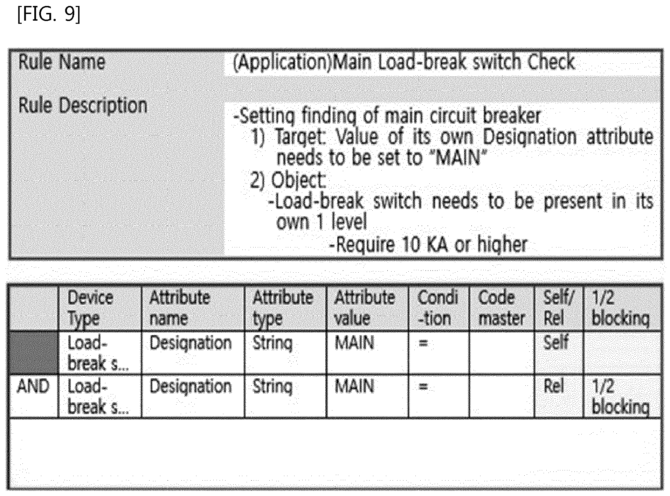

FIGS. 9 to 14 are diagrams for describing a generation rule operation of the management system of the electrical field circuit design according to the exemplary embodiment of the present invention.

Referring to FIG. 9, a generation rule for checking a main circuit breaker and the description for the generation rule and the parameters are schematically illustrated.

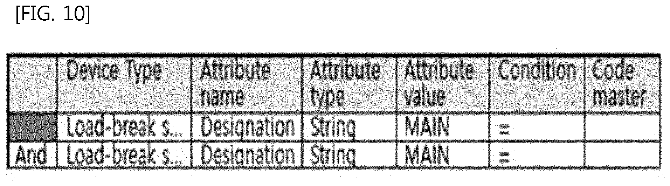

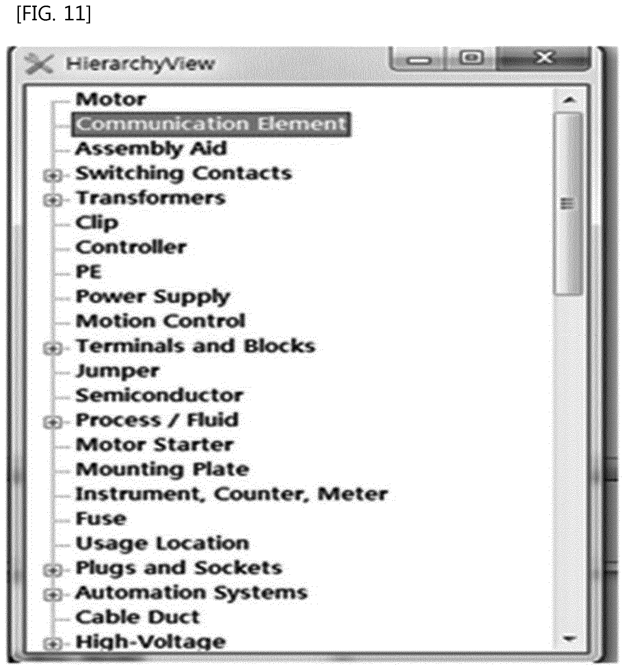

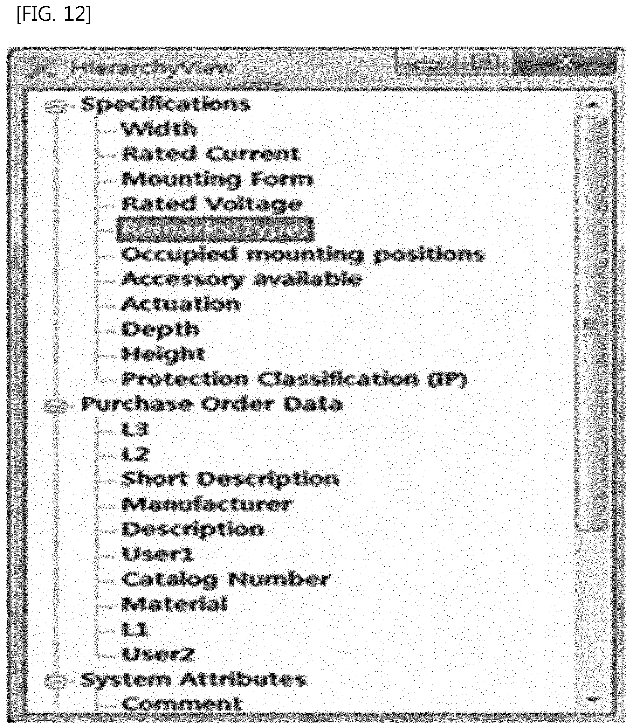

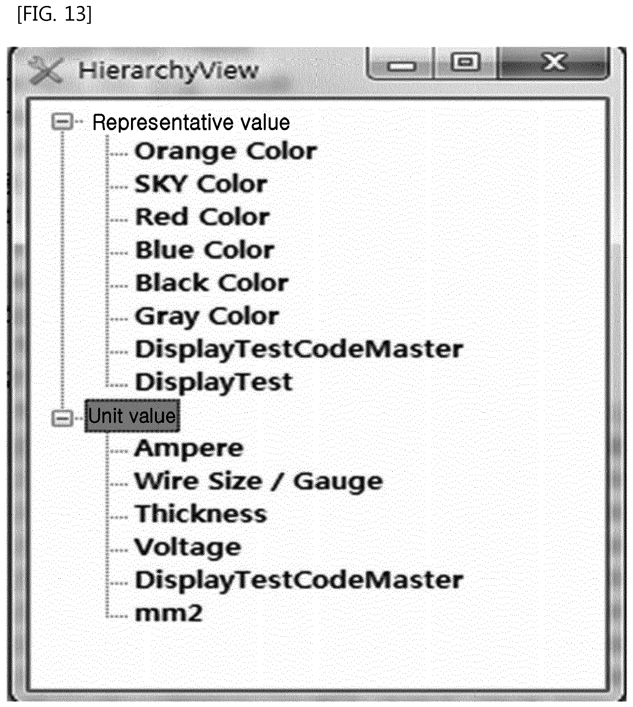

Referring to FIG. 10, a connection condition of the parameters of the generation rule is illustrated, and referring to FIG. 11, a list of device types may be listed and selected. Referring to FIG. 12, a list capable of inputting attribute names may be listed and selected, and referring to FIG. 13, a representative value and a unit value are selected to select the code master.

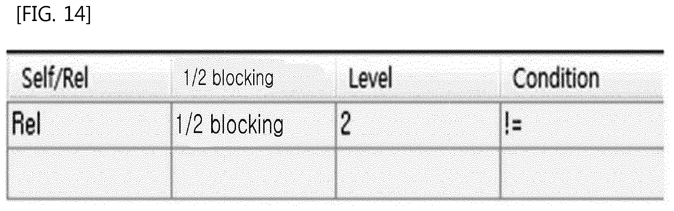

Referring to FIG. 14, a linkage relationship such as a connection relation, a search direction, a device level, a condition, and the like may be set to be included in the generation rule as a parameter. A Self/Rel item is a parameter that can select whether the target device is self or if not, a device located at a specific level from a specific device, and a 1/2 blocking is a parameter for setting a search direction when Rel is selected from the Self/Rel item. Level is a parameter indicating a range of a searchable device based on the target device and Condition is a parameter for setting a search condition of the device.

As an example, if a used current attribute of the main circuit breaker should be 10 KA, in the Self/Ref item, Self is selected and 1/2 blocking may not be selected, and Condition is =, an attribute is a used current, and an attribute value may be set as 10 KA.

As another example, in the case of a lamp (used current of 10 KA) primarily next to the main circuit breaker, in the Self/Ref item, Ref is selected and a 1/2 blocking value is a primary end, a level is 1, and Condition is =, the device is Lamp, an attribute is a used current, and an attribute value may be set as 10 KA.

The term 'unit' used in the exemplary embodiment means software or a hardware component such as a field-programmable gate array (FPGA) or ASIC and the 'unit' performs certain roles. However, the 'unit' is not a meaning limited to software or hardware. The "unit' may be configured to be positioned in an addressable storage medium and configured to reproduce one or more processors. Therefore, as one example, the 'unit' includes components such as software components, object oriented software components, class components, and task components, processes, functions, attributes, procedures, subroutines, segments of a program code, drivers, firmware, a microcode, a circuit, data, a database, data structures, tables, arrays, and variables. Functions provided in the components and 'units' may be joined as a smaller number of components and 'units'or further separated into additional components and 'units'. In addition, the components and 'units' may also be implemented to reproduce one or more CPUs in a device or a secure multimedia card.

## Claims

1. A management system of an electrical field circuit design, comprising:
a rule generator that generates a rule applied individually to a specific device of a specific project, including parameters of a device type, a connection condition, an attribute name, an attribute type, an attribute value, an attribute value condition, a code master, a target device condition, and a setting range;
a rule manager that manages a generation rule generated by the rule generator, a basic wire rule for the electrical field design, and a device rule;
a rule check unit that determines whether to apply and match a basic wire rule and a device rule to the inputted electrical field circuit design, confirms a project of the electrical field circuit design, and determines whether to apply and match the generation rule to a specific device included therein; and
a result generator that generates a matching result of the basic wire rule, the device rule, and the generation rule,
wherein the device type is a parameter for setting a type of component used in the electrical field circuit design,
the connection condition is a parameter for setting a linkage condition between rules,
the attribute name is a parameter for setting an attribute defined for each device type,
the attribute type is a parameter for setting a type of value that may be input in the attribute,
the attribute value is a parameter for setting a value for distinguishing a MAIN device from other devices,
the attribute value condition is a parameter for setting a logic condition of the input attribute value, and
the code master is a parameter for setting a representative value and a unit of the input attribute value.

2. The management system of an electrical field circuit design of claim 1, wherein the rule generator distinguishes a hierarchical structure between generation rules using at least one registered parameter of the device type, the connection condition, the attribute name, the attribute type, the attribute value, the attribute value condition, the code master, the target device condition, and the setting range.

3. The management system of an electrical field circuit design of claim 1, wherein the rule generator provides an interface for updating, changing, and deleting the generation rule.

4. The management system of an electrical field circuit design of claim 1, wherein the result generator generates the matching result for each device or wire.

5. The management system of an electrical field circuit design of claim 1, wherein the rule check unit determines whether or not to match the generation rule by distinguishing a rule for determining whether or not to match the generation rule according to the input of the user and a rule for not determining.
